# EUROPEAN PATENT APPLICATION

(11) **EP 4 701 395 A1**
(43) Date of publication of application: **25.02.2026**
(21) Application number: 25184406.4
(22) Date of filing: 23.06.2025
(51) Int. Cl.: H10N 70/20, H10B 63/00

(54) **OVONIC THRESHOLD SWITCHING MATERIAL AND VERTICAL MEMORY DEVICE INCLUDING THE SAME**

(30) Priority: 23.08.2024 KR 20240113705
(71) Applicant: Samsung Electronics Co., Ltd., Suwon-si, Gyeonggi-do 16677 (KR)
(72) Inventor: CHOI, Minwoo, 16678 Suwon-si (KR); KANG, Youngjae, 16678 Suwon-si (KR); KOO, Bonwon, 16678 Suwon-si (KR); PARK, Jongbong, 16678 Suwon-si (KR); SUNG, Hajun, 16678 Suwon-si (KR); YANG, Kiyeon, 16678 Suwon-si (KR); YANG, Wooyoung, 16678 Suwon-si (KR); HAM, Yongnam, 16678 Suwon-si (KR)
(74) Representative: Elkington and Fife LLP

(57) **Abstract**

Provided are an Ovonic threshold switching material and a vertical memory device including the Ovonic threshold switching material. The Ovonic threshold switching material includes germanium (Ge), antimony (Sb), and selenium (Se), wherein a ratio of Ge among Ge, Sb, and Se is 10 at% or more and 40 at% or less, a ratio of Sb among Ge, Sb, and Se is 10 at% or more and 40 at% or less, and a ratio of Se among Ge, Sb, and Se is 20 at% or more and 80 at% or less, and the Ovonic threshold switching material is doped with indium (In).

## Description

### FIELD OF THE INVENTION

The disclosure relates to Ovonic threshold switching materials and vertical memory devices including the same.

### BACKGROUND OF THE INVENTION

Chalcogenide-based Ovonic threshold switching elements exhibit an abrupt decrease in resistance above a threshold voltage and electrically reversible characteristics of returning to a high-resistance state at a voltage below the threshold voltage and are therefore mainly used as selectors for cross-point memory cells. Recently, a selector-only memory (SOM) has been proposed, in which a selector also functions as a memory layer by using an Ovonic threshold switching element with two different threshold voltages depending on the electrical polarity.

A cross-point memory structure has limitations in increasing a degree of integration of the memory because the area of a driving part increases as the cell density increases. Accordingly, although a memory device having a vertical structure has been proposed, it is difficult to implement a memory device having a vertical structure because it is difficult to deposit currently known Ovonic threshold switching materials using an atomic layer deposition (ALD) method.

### SUMMARY OF THE INVENTION

Provided are Ovonic threshold switching materials that may be deposited using an atomic layer deposition method.

Furthermore, provided are vertical memory devices including an Ovonic threshold switching material that may be deposited using an atomic layer deposition method.

Additional aspects will be set forth in part in the description which follows and, in part, will be apparent from the description, or may be learned by practice of the presented example embodiments.

According to an example embodiment of the disclosure, an Ovonic threshold switching material includes germanium (Ge), antimony (Sb), and selenium (Se), wherein a ratio of Ge is 10 at% or more and 40 at% or less, a ratio of Sb is 10 at% or more and 40 at% or less, and a ratio of Se is 20 at% or more and 80 at% or less, and the Ovonic threshold switching material is doped with indium (In).

For example, a doping concentration of In in the Ovonic threshold switching material may be greater than 0 at% and less than or equal to10 at%.

For example, a doping concentration of In in the Ovonic threshold switching material may be 1 at% or more and 10 at% or less.

For example, a doping concentration of In in the Ovonic threshold switching material may be 1.5 at% or more and 10 at% or less.

For example, a doping concentration of In in the Ovonic threshold switching material may be 1 at% or more and 5 at% or less.

For example, a doping concentration of In in the Ovonic threshold switching material may be 1.5 at% or more and 5 at% or less.

Furthermore, of the Ge, the Sb, and the Se, the ratio of Ge may be 20 at% or more and 35 at% or less, and the ratio of Sb may be 20 at% or more and 35 at% or less, and the ratio of Se may be 30 at% or more and 60 at% or less.

A concentration of arsenic (As) in the Ovonic threshold switching material may be 0 at%.

A threshold voltage drift of the Ovonic threshold switching material may be in a range from 6 mV/dec to 7 mV/dec.

According to an example embodiment of the disclosure, a memory device includes a plurality of word planes extending along a plane including a first direction and a second direction, the plurality of word planes spaced apart from each other in a third direction perpendicular to the first direction and the second direction, a plurality of vertical bit lines extending in the third direction, and a plurality of Ovonic threshold switching material layers surrounding a surface of each of the plurality of vertical bit lines and extending in the third direction, wherein the plurality of Ovonic threshold switching material layers include germanium (Ge), antimony (Sb), and selenium (Se), of the Ge, the Sb, and the Se, a ratio of Ge is 10 at% or more and 40 at% or less, a ratio of Sb is 10 at% or more and 40 at% or less, and a ratio of Se is 20 at% or more and 80 at% or less, and the plurality of Ovonic threshold switching material layers are doped with indium (In).

The plurality of Ovonic threshold switching material layers and the plurality of vertical bit lines may pass through the plurality of word planes in the third direction and may be two-dimensionally arranged in the first direction and the second direction, and the plurality of word planes may surround external surfaces of the plurality of Ovonic threshold switching material layers.

The memory device may further include a plurality of dielectric layers surrounding external surfaces of the plurality of Ovonic threshold switching material layers, each of the plurality of dielectric layers being between two adjacent ones of the plurality of word planes that are adjacent to each other in the third direction.

### BRIEF DESCRIPTION OF THE DRAWINGS

These and/or other aspects will become apparent and more readily appreciated from the following description of some example embodiments, taken in conjunction with the accompanying drawings in which:
FIG. 1 is a perspective view schematically showing a structure of a memory device according to an example embodiment;
FIG. 2 is a horizontal cross-sectional view schematically showing a configuration of one memory cell in the memory device illustrated in FIG. 1;
FIG. 3 is a vertical cross-sectional view schematically showing a configuration of one memory cell string in the memory device illustrated in FIG. 1;
FIG. 4 is a graph showing an example of voltage-current characteristics of an Ovonic threshold switching material layer of a memory device;
FIG. 5A is a graph showing an example of a bias voltage for a set (SET) operation and a read operation in a memory device according to an example embodiment;
FIG. 5B is a graph showing an example of a bias voltage for a reset (RESET) operation and a read operation in a memory device according to an example embodiment;
FIG. 6 is a graph showing an example of an element composition ratio of an Ovonic threshold switching material layer according to an example embodiment;
FIG. 7 is a graph showing an example of a change in threshold voltage depending on a doping concentration of indium (In) in an Ovonic threshold switching material layer according to an example embodiment;
FIG. 8 is a graph showing an example of a change in threshold voltage drift depending on a doping concentration of In in an Ovonic threshold switching material layer according to an example embodiment;
FIG. 9 is a graph showing an example of a change in leakage current depending on a doping concentration of In in an Ovonic threshold switching material layer according to an example embodiment;
FIG. 10 is a graph showing an example of a change in memory window depending on a doping concentration of In in an Ovonic threshold switching material layer according to an example embodiment;
FIG. 11 is a graph showing an example of a change in threshold voltage depending on the frequency of operations in an Ovonic threshold switching material layer according to an example embodiment;
FIG. 12 is a graph showing an example of a change in memory window depending on the intensity of a writing voltage in an Ovonic threshold switching material layer according to an example embodiment; and
FIG. 13 is a schematic conceptual view of a device architecture applicable to an electronic apparatus according to an example embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects. Expressions such as "at least one of," "one of," and "any one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes

Hereinbelow, Ovonic threshold switching material and a vertical memory device including the same are described in detail with reference to the accompanying drawings. Throughout the drawings, like reference numerals denote like elements, and sizes of components in the drawings may be exaggerated for convenience of explanation, and clarity. Furthermore, as embodiments described below are examples, other modifications may be produced from the embodiments.

When a constituent element is disposed "above" or "on" to another constituent element, the constituent element may include not only an element directly contacting and disposed on the other constituent element, but also an element disposed above the other constituent element in a non-contact manner. As used herein, the singular forms "a," "an," and "the" are intended to include the plural forms as well, unless the context clearly indicates otherwise. It will be further understood that the terms "comprises" and/or "comprising" used herein specify the presence of stated features or components, but do not preclude the presence or addition of one or more other features or components

The use of the terms "a" and "an" and "the" and similar referents in the context of describing the disclosure are to be construed to cover both the singular and the plural. Also, the steps of all methods described herein can be performed in any suitable order unless otherwise indicated herein or otherwise clearly contradicted by context. The disclosure is not limited to the described order of the steps.

Furthermore, terms such as "... portion," "... unit," "... module," and "... block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed.

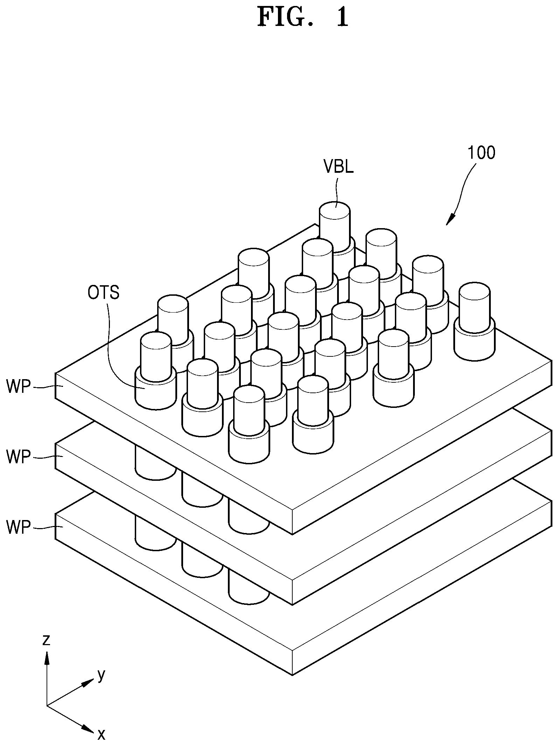

FIG. 1 is a perspective view schematically showing a structure of a memory device 100 according to an example embodiment. Referring to FIG. 1, the memory device 100 according to an memory device embodiment may include a plurality of word planes (WP) extending along a plane including a first direction (e.g., an X-axis direction) and a second direction (e.g., a Y-axis direction) and spaced apart from each other in a third direction (e.g., a Z-axis direction) perpendicular to the first direction and the second direction, a plurality of vertical bit lines VBL extending in the third direction and two-dimensionally arranged in the first direction and the second direction, and a plurality of Ovonic threshold switching material layers OTS respectively surrounding surfaces of the vertical bit lines VBL and extending in the third direction. The Ovonic threshold switching material layers OTS may be two-dimensionally arranged in the first direction and the second direction, like the vertical bit lines VBL.

Each of the Ovonic threshold switching material layers OTS and each of the vertical bit lines VBL may be disposed to pass through the word planes WP in the third direction. As the Ovonic threshold switching material layers OTS and the vertical bit lines VBL extend in a vertical direction, the memory device 100 illustrated in FIG. 1 may be referred to as a vertical memory device and may have a relatively high degree of integration and improved memory capacity.

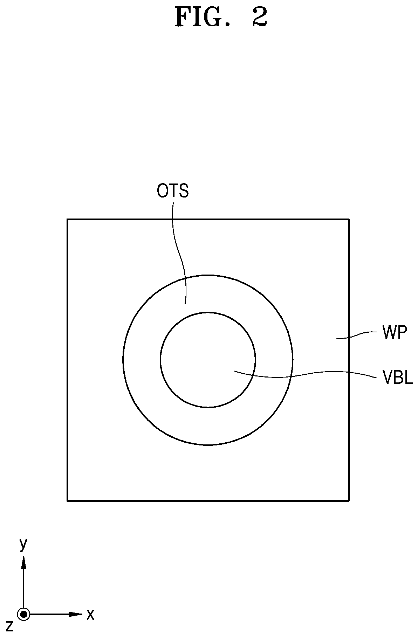

FIG. 2 is a horizontal cross-sectional view schematically showing a configuration of one memory cell in the memory device 100 illustrated in FIG. 1. Referring to FIG. 2, the vertical bit line VBL may have, for example, a cylindrical shape. Furthermore, the Ovonic threshold switching material layer OTS may have a cylindrical shape surrounding the vertical bit line VBL. The Ovonic threshold switching material layer OTS may have a ring shape in a horizontal cross-sectional view. The external surface of the Ovonic threshold switching material layer OTS may be surrounded by the word plane WP.

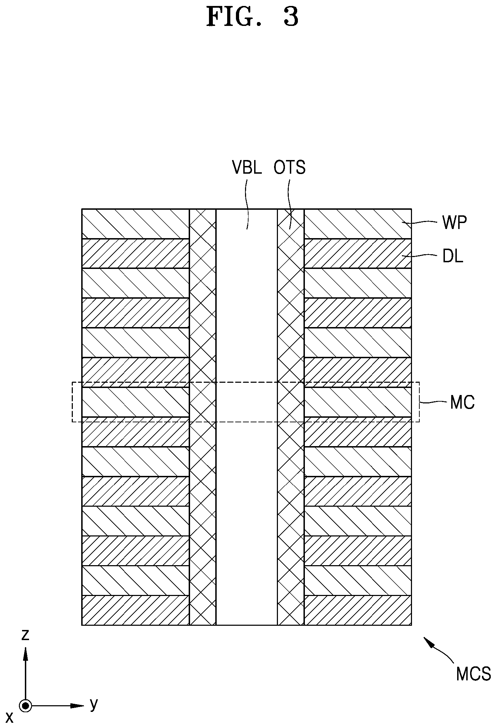

FIG. 3 is a vertical cross-sectional view schematically showing a configuration of one memory cell string MCS in the memory device 100 illustrated in FIG. 1. Referring to FIG. 3, the memory cell string MCS extending in the third direction may include the vertical bit line VBL extending in the third direction, the Ovonic threshold switching material layer OTS surrounding the vertical bit line VBL and extending in the third direction, the word planes WP surrounding the external surface of the Ovonic threshold switching material layer OTS and spaced apart from each other in the third direction, and a plurality of dielectric layers DL surrounding the external surface of the Ovonic threshold switching material layer OTS, each of the dielectric layers DL being provided between two adjacent word planes WP that are adjacent to each other in the third direction. The dielectric layers DL may be spacers to maintain a spacing between the two adjacent word planes WP.

A portion of the Ovonic threshold switching material layer OTS and a portion of the vertical bit line VBL, which are surrounded by one word plane WP on a plane (e.g., an X-Y plane) in the first direction and the second direction, may constitute one memory cell MC with the word plane WP corresponding thereto. Accordingly, the memory cell string MCS may include a plurality of memory cells MC spaced apart from each other in the third direction. The memory device 100 may include a plurality of memory cell strings MCS two-dimensionally arranged in the first direction and the second direction. In this respect, it may be seen that the memory cells MC three-dimensionally arranged in the first direction, the second direction, and the third direction. Each word plane WP may simultaneously provide a driving voltage or a read voltage to the memory cells MC two-dimensionally arranged on the same plane.

The word plane WP and the vertical bit line VBL may include a conductive material. The dielectric layer DL may include, for example, an insulating dielectric material, such as SiO₂, SiN, Al₂O₃ or HfO₂.

The Ovonic threshold switching material layer OTS may include a material having Ovonic threshold switching characteristics. For example, the Ovonic threshold switching material layer OTS may have the characteristics of a memory in which a threshold voltage is shifted depending on the polarity and intensity of an applied bias voltage. Accordingly, the Ovonic threshold switching material layer OTS may have the characteristics of a self-selecting memory that can perform both of a memory function and a selector function with a single material only. To this end, the Ovonic threshold switching material layer OTS may include a single material of multi-component chalcogenide.

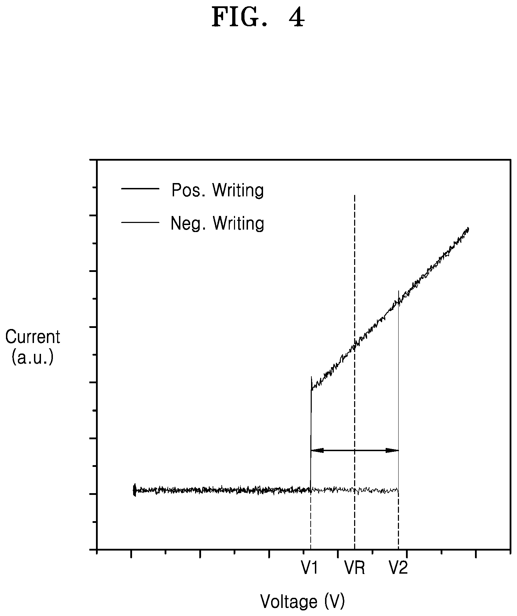

FIG. 4 is a graph showing an example of voltage-current characteristics of the Ovonic threshold switching material layer OTS of the memory device 100. Referring to FIG. 4, the Ovonic threshold switching material layer OTS may have any one state among a first state (a low Vth state (LVS)) in which a threshold voltage is relatively low and a second state (a high Vth state (HVS)) in which the threshold voltage is relatively high. For example, in the first state, the threshold voltage of the Ovonic threshold switching material layer OTS may be a first voltage V1, and in the second state, the threshold voltage of the Ovonic threshold switching material layer OTS may be a second voltage V2 greater than the first voltage V1. When the Ovonic threshold switching material layer OTS is in the first state and a voltage less than the first voltage V1 is applied to the Ovonic threshold switching material layer OTS, current hardly flows in the Ovonic threshold switching material layer OTS, and when a voltage greater than the first voltage V1 is applied to the Ovonic threshold switching material layer OTS, the Ovonic threshold switching material layer OTS is turned on so that current flows through the Ovonic threshold switching material layer OTS. Furthermore, when the Ovonic threshold switching material layer OTS is in the second state and a voltage less than the second voltage V2 is applied to the Ovonic threshold switching material layer OTS, current hardly flows in the Ovonic threshold switching material layer OTS, and when a voltage greater than the second voltage V2 is applied to the Ovonic threshold switching material layer OTS, the Ovonic threshold switching material layer OTS is turned on so that current flows through the Ovonic threshold switching material layer OTS.

Accordingly, a voltage between the first voltage V1 and the second voltage V2 may be selected as a read voltage VR. When the Ovonic threshold switching material layer OTS is in the first state and the read voltage VR is applied to the Ovonic threshold switching material layer OTS, current flows through the Ovonic threshold switching material layer OTS, and in this state, a data value stored in the Ovonic threshold switching material layer OTS may be defined to be "1." When the Ovonic threshold switching material layer OTS is in the second state and the read voltage VR is applied to the Ovonic threshold switching material layer OTS, current hardly flows through the Ovonic threshold switching material layer OTS, and in this state, a data value stored in the Ovonic threshold switching material layer OTS may be defined to be "0." In other words, while the read voltage VR is applied to the Ovonic threshold switching material layer OTS, by measuring current flowing in the Ovonic threshold switching material layer OTS, the data value stored in the Ovonic threshold switching material layer OTS may be read out.

In a state in which the Ovonic threshold switching material layer OTS is in the first state, when a negative (-) bias voltage is applied to the Ovonic threshold switching material layer OTS, the threshold voltage of the Ovonic threshold switching material layer OTS increases, and thus, the Ovonic threshold switching material layer OTS may be switched to the second state (negative writing). For example, when a negative third voltage is applied to the Ovonic threshold switching material layer OTS, the Ovonic threshold switching material layer OTS may be switched to the second state. Such an operation may be referred to as a 'reset (RESET)' operation. Furthermore, in a state in which the Ovonic threshold switching material layer OTS is in the second state, when a positive (+) bias voltage greater than the second voltage V2 is applied to the Ovonic threshold switching material layer OTS, the threshold voltage of the Ovonic threshold switching material layer OTS decreases, and thus, the Ovonic threshold switching material layer OTS may be switched to the first state (positive writing). Such an operation may be referred to as a 'set (SET)' operation.

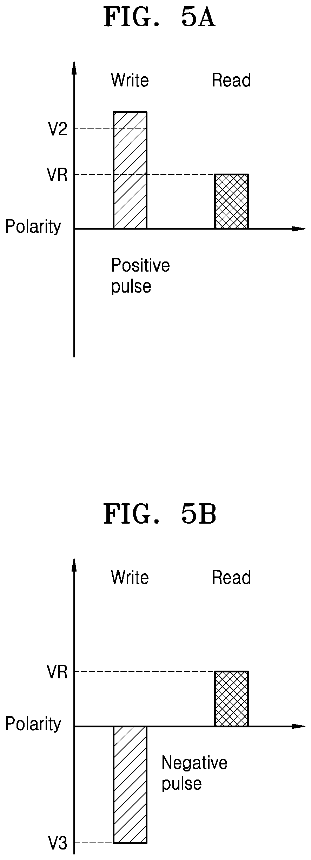

FIG. 5A is a graph showing an example of a bias voltage for a set (SET) operation and a read operation in the memory device 100 according to an example embodiment. Referring to FIG. 5A, in the set (SET) operation, a positive bias voltage greater than the second voltage V2 may be applied to the Ovonic threshold switching material layer OTS. Then, the threshold voltage of the Ovonic threshold switching material layer OTS may be shifted to the first voltage V1. Then, in the read operation, the positive read voltage VR between the first voltage V1 and the second voltage V2 may be applied to the Ovonic threshold switching material layer OTS. When the read voltage VR is applied to the Ovonic threshold switching material layer OTS, the Ovonic threshold switching material layer OTS may be turned on.

FIG. 5B is a graph showing an example of a bias voltage for a reset (RESET) operation and a read operation in the memory device 100 according to an example embodiment. Referring to FIG. 5B, in the reset (RESET) operation, a negative bias voltage, for example, a negative third voltage V3 may be applied to the Ovonic threshold switching material layer OTS. The absolute value of the third voltage V3 may be approximately the same as or slightly greater or less than the second voltage V2. Then, the threshold voltage of the Ovonic threshold switching material layer OTS may be shifted to the second voltage V2 greater than the first voltage V1. Then, in the read operation, the positive read voltage VR between the first voltage V1 and the second voltage V2 may be applied to the Ovonic threshold switching material layer OTS. When the read voltage VR is applied to the Ovonic threshold switching material layer OTS, the Ovonic threshold switching material layer OTS may be turned off.

As described above, the Ovonic threshold switching material layer OTS of the memory device 100 according to an example embodiment may have the characteristics of a memory with variable threshold voltage while having the Ovonic threshold switching characteristics. For example, the threshold voltage of the Ovonic threshold switching material layer OTS may be shifted depending on the polarity of a bias voltage applied to the Ovonic threshold switching material layer OTS. Accordingly, each memory cell MC of the memory device 100 according to an example embodiment does not need to include a separate selector layer and a separate memory layer, and may perform a switching operation and a memory operation with only one Ovonic threshold switching material layer OTS. In this respect, the memory device 100 according to an example embodiment may be a selector only memory (SOM), in particular a vertical SOM (VSOM) because the memory device 100 has a vertical structure in which the memory cells MC are arranged in the vertical direction.

According to an example embodiment, the Ovonic threshold switching material of the Ovonic threshold switching material layer OTS having the characteristics described above may be, for example, a single material of multi-component chalcogenide including germanium (Ge), antimony (Sb), and selenium (Se). For example, the Ovonic threshold switching material layer OTS according to an example embodiment may include Ge-Sb-Se doped with indium (In) and may not include arsenic (As). In other words, the concentration of As in the Ovonic threshold switching material layer OTS according to an example embodiment may be about 0 at%.

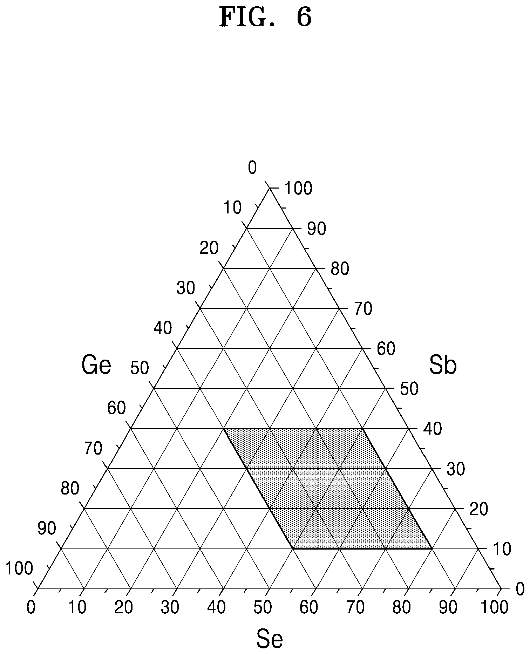

FIG. 6 is a graph showing an example of an element composition ratio of an Ovonic threshold switching material layer OTS according to an example embodiment. Referring to FIG. 6, in Ge-Sb-Se that is the material of the Ovonic threshold switching material layer OTS, a ratio of Ge may be, for example, about 10 at% or more and about 40 at% or less, a ratio of Sb may be, for example, about 10 at% or more and about 40 at% or less, and a ratio of Se may be, for example, about 20 at% or more and about 80 at% or less. FIG. 6 shows a composition between Ge, Sb, and Se, excluding In, of the material of the Ovonic threshold switching material layer OTS.

According to an example embodiment, in order to implement the memory device 100 illustrated in FIGS. 1 to 3, the Ovonic threshold switching material layer OTS may be formed by uniformly depositing the Ovonic threshold switching material on the surface of the vertical bit line VBL in an atomic layer deposition (ALD) method. Generally, it is difficult to deposit a chalcogenide material including As in an ALD method because no precursor for depositing an As-Se atomic layer has been developed. In contrast, the Ovonic threshold switching material of the Ovonic threshold switching material layer OTS according to an example embodiment does not include As (i.e., includes 0% As) so as to be deposited in the ALD method, and thus, the memory device 100 according to an example embodiment, which is a VSOM may be relatively easily implemented.

Furthermore, by doping a small amount of In in Ge-Sb-Se, the Ovonic threshold switching material layer OTS according to an example embodiment may have variously improved characteristics.

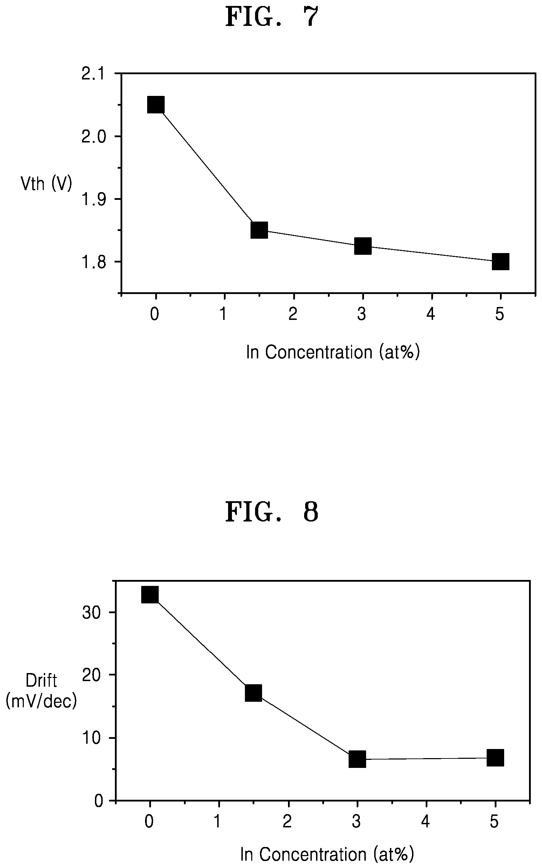

FIG. 7 is a graph showing an example of a change in threshold voltage depending on a doping concentration of In in the Ovonic threshold switching material layer OTS according to an example embodiment. Referring to FIG. 7, as the doping concentration of In in the Ovonic threshold switching material layer OTS increases, the threshold voltage of the Ovonic threshold switching material layer OTS may be gradually decreased. In FIG. 7, a threshold voltage Vth is a threshold voltage in a set state or the first state LVS. Furthermore, in FIG. 7, the doping concentration of In represents a percentage (at%) of the number of In atoms to the total number of atoms in the Ovonic threshold switching material layer OTS. When the concentration of In in the Ovonic threshold switching material layer OTS is about 5 at%, the threshold voltage of the Ovonic threshold switching material layer OTS may be about 1.8 V that is relatively low. As the Ovonic threshold switching material layer OTS including Ge-Sb-Se doped with In has a relatively low threshold voltage, the memory device 100 may operate at a relatively low voltage, and thus, the memory device 100 may be applied to various low power devices.

In FIG. 7, a composition of Ge, Sb, and Se is maintained constant regardless of the doping concentration of In. For example, in an example illustrated in FIG. 7, among Ge, Sb, and Se, the ratio of Ge may be about 27 at%, the ratio of Sb may be about 24.5 at%, and the ratio of Se may be about 48.5 at%. The composition of Ge, Sb, and Se described above may be applied to the graphs of FIGS. 8 to 12 described below.

FIG. 8 is a graph showing an example of a change in threshold voltage drift depending on a doping concentration of In in the Ovonic threshold switching material layer OTS according to an example embodiment. Referring to FIG. 8, as the doping concentration of In in the Ovonic threshold switching material layer OTS increases, the threshold voltage drift of the Ovonic threshold switching material layer OTS may be gradually decreased. For example, when the concentration of In in the Ovonic threshold switching material layer OTS is about 3 at% or more, the threshold voltage drift of the Ovonic threshold switching material layer OTS may be about 10 mV/dec or less, or may be in a range from 6 mV/dec to 7 mV/dec. Accordingly, a change level in threshold voltage of the Ovonic threshold switching material layer OTS depending on the passage of time or an increase in the frequency of operations may be relatively low. The Memory device 100 including the Ovonic threshold switching material layer OTS may have relatively stable operating characteristics.

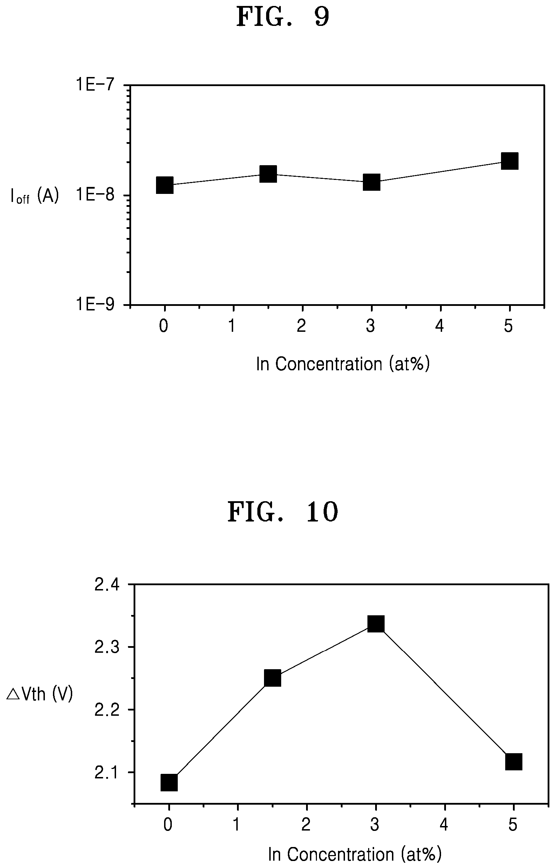

FIG. 9 is a graph showing an example of a change in leakage current depending on a doping concentration of In in the Ovonic threshold switching material layer OTS according to an example embodiment. Referring to FIG. 9, as the doping concentration of In in the Ovonic threshold switching material layer OTS increases, the leakage current (I_{off}) of the Ovonic threshold switching material layer OTS slightly increases. However, as a whole, the leakage current (I_{off}) of the Ovonic threshold switching material layer OTS may be maintained as relatively low as about 12 nA to about 21 nA. Accordingly, the Memory device 100 including the Ovonic threshold switching material layer OTS may have relatively low power consumption and relatively stable operating characteristics. Although not shown in the graph of FIG. 9, the doping concentration of In in the Ovonic threshold switching material layer OTS may be limited to about 10 at% or less to reduce or prevent an excessive increase of a leakage current.

FIG. 10 is a graph showing an example of a change in memory window depending on a doping concentration of In in the Ovonic threshold switching material layer OTS according to an example embodiment. A memory window is a difference between two threshold voltages of the Ovonic threshold switching material layer OTS. For example, when, in the first state, the threshold voltage of the Ovonic threshold switching material layer OTS is the first voltage V1 and, in the second state, the threshold voltage of the Ovonic threshold switching material layer OTS is the second voltage V2, a memory window ΔVth may be (V2 - V1). As the memory window ΔVth increases, a distinction between the first state and the second state may become clearer, and thus, the operation reliability of the memory device 100 may be improved. Referring to FIG. 10, until the doping concentration of In in the Ovonic threshold switching material layer OTS is about 3 at%, as the doping concentration of In increases, the memory window ΔVth may be gradually increased. When the doping concentration of In exceeds about 3 at%, as the doping concentration of In increases, the memory window ΔVth may be gradually decreased. For example, when the doping concentration of In in the Ovonic threshold switching material layer OTS is about 3 at%, the memory window ΔVth may have the maximum value of about 2.3 V or more, for example, about 2.34 V.

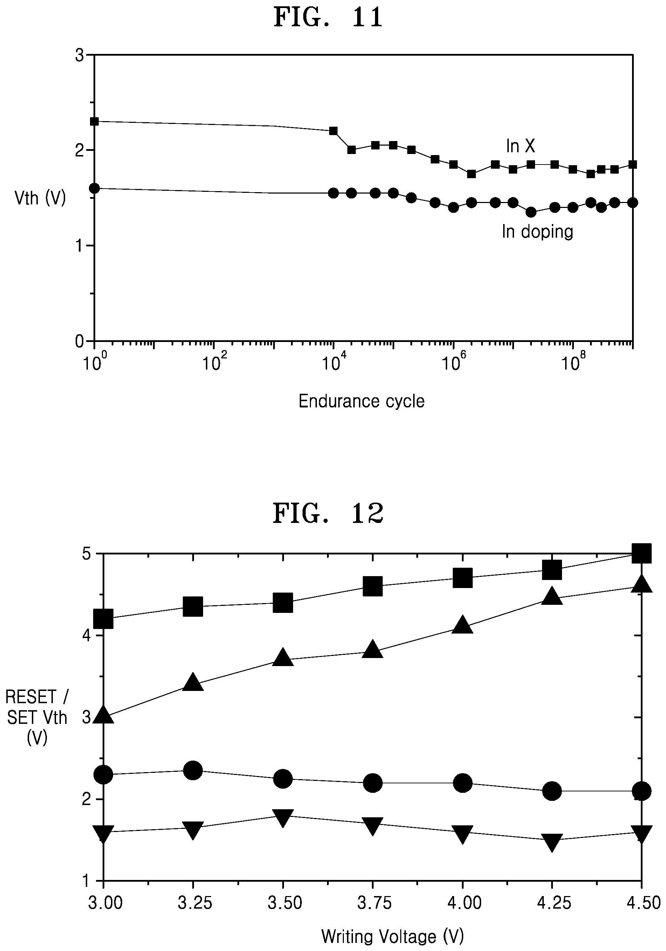

FIG. 11 is a graph showing an example of a change in threshold voltage depending on the frequency of operations in the Ovonic threshold switching material layer OTS according to an example embodiment, and FIG. 12 is a graph showing an example of a change in memory window depending on the intensity of a writing voltage in the Ovonic threshold switching material layer OTS according to an example embodiment. FIGS. 11 and 12 show a comparison between a comparative example undoped with In and an example embodiment doped with In. In the example embodiment doped with In, the doping concentration of In in the Ovonic threshold switching material layer OTS is about 1.5 at%, and in the comparative example undoped with In, the doping concentration of In in the Ovonic threshold switching material layer OTS is about 0 at%. Furthermore, in the example embodiment and the comparative example, of Ge, Sb, and Se, the ratio of Ge may be about 27 at%, the ratio of Sb may be about 24.5 at%, and the ratio of Se may be about 48.5 at%.

In FIG. 11, a graph indicated by circles (•) represents the example embodiment in which In is doped at a concentration of about 1.5 at%, and a graph indicated by squares (▪) represents the comparative example undoped with In. Referring to FIG. 11, the threshold voltage of the example embodiment in which In is doped at a concentration of about 1.5 at% may be less than the threshold voltage of the comparative example undoped with In. Furthermore, compared with the comparative example undoped with In, in the example embodiment in which In is doped at a concentration of about 1.5 at%, a change in threshold voltage depending on the frequency of operations may be smaller. For example, in the example embodiment in which In is doped at a concentration of about 1.5 at%, even after an operation of 1G cycle is performed, the threshold voltage may be almost maintained in the initial state. In FIG. 11, the threshold voltage Vth is the threshold voltage in the set state or the first state LVS.

In FIG. 12, a graph indicated by inverted triangles (▼) represents the threshold voltage in the set state or the first state LVS in the example embodiment in which In is doped at a concentration of about 1.5 at%, and a graph indicated by triangles (▲) represents the threshold voltage in the reset state or the second state HVS in the example embodiment in which In is doped at a concentration of about 1.5 at%. Furthermore, in FIG. 12, a graph indicated by circles (•) represents the threshold voltage in the set state or the first state LVS in the comparative example undoped with In, and a graph indicated by squares (▪) represents the threshold voltage in the reset state or the second state HVS in the comparative example undoped with In. Referring to FIG. 12, regardless of the intensity of a writing voltage to make the Ovonic threshold switching material layer OTS into the set state, the threshold voltage of the example embodiment in which In is doped at a concentration of about 1.5 at% may be less than the threshold voltage of the comparative example undoped with In. Furthermore, as the writing voltage increases, compared with the memory window of the comparative example undoped with In, the memory window of the example embodiment in which In is doped at a concentration of about 1.5 at% may be further increased to be larger.

Considering the results described with reference to FIGS. 7 to 12, the doping concentration of In in the Ovonic threshold switching material layer OTS according to an example embodiment may be greater than 0 at% and less than or equal to about 10 at%. According to some example embodiments, the doping concentration of In in the Ovonic threshold switching material layer OTS may be about 1 at% or more and about 10 at% or less, about 1.5 at% or more and about 10 at% or less, about 3 at% or more and about 10 at% or less, about 1 at% or more and about 5 at% or less, about 1.5 at% or more and about 5 at% or less, or about 3 at% or more and about 5 at% or less. Furthermore, of Ge, Sb, and Se, the ratio of Ge may be about 20 at% or more and about 35 at% or less, and the ratio of Sb may be about 20 at% or more and about 35 at% or less, and the ratio of Se may be about 30 at% or more and about 60 at% or less.

When a voltage V is to be applied to the Ovonic threshold switching material layer OTS of any one memory cell (hereinafter, referred to as "selected memory cell") selected from among the memory cells MC three-dimensionally arranged of the memory device 100 illustrated in FIGS. 1 to 3, the voltage V may be provided to the word plane WP of the selected memory cell and a voltage V/2 may be provided to the other word planes WP. Furthermore, a voltage of 0 V may be provided to the vertical bit line VBL of the selected memory cell, and the voltage V/2 may be provided to the other vertical bit lines VBL. Then, a potential difference between the word plane WP and the vertical bit line VBL of the selected memory cell amounts to V. In contrast, a potential difference between the word plane WP to which the voltage V/2 is provided and the vertical bit line VBL to which the voltage V/2 is provided amounts to 0 V. Accordingly, no voltage is applied to an unselected memory cell arranged between the word plane WP and the vertical bit line VBL that are not connected to the selected memory cell. The voltage V/2 may be applied to the Ovonic threshold switching material layer OTS of the memory cell (hereinafter, referred to as "half-selected memory cell") connected to the same word plane WP as the word plane WP of the selected memory cell MC or the same vertical bit line VBL as the vertical bit line VBL of the selected memory cell MC. The Ovonic threshold switching material layer OTS according to an example embodiment is a self-selecting device having the threshold voltage as described above. Accordingly, even when the voltage V/2 is applied to the Ovonic threshold switching material layer OTS of the half-selected memory cell neighboring the selected memory cell, the Ovonic threshold switching material layer OTS of the half-selected memory cell may not be turned on, and thus, leakage current may hardly occur.

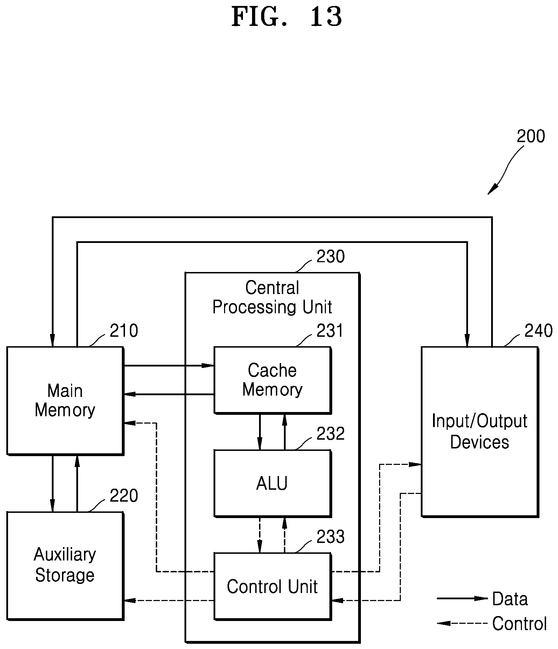

The memory device 100 described above may be used to store data in various electronic apparatuses. FIG. 13 is a schematic conceptual view of a device architecture applicable to an electronic apparatus 200 according to an example embodiment. Referring to FIG. 13, the electronic apparatus 200 may include a main memory 210, an auxiliary storage 220, a central processing unit (CPU) 230, and input/output devices 240. The CPU 230 may include a cache memory 231, an arithmetic logic unit (ALU) 232, and a control unit 233. The cache memory 231 may include static random access memory (SRAM). The main memory 210 may include a DRAM device, and the auxiliary storage 220 may include the memory device 100 according to an example embodiment. The cache memory 231, the main memory 210, and the auxiliary storage 220 may all include the memory device 100 according to an example embodiment. In some cases, the electronic apparatus 200 may be implemented in the form of computing unit devices and memory unit devices being adjacent to each other in one chip, without distinction of the sub-units described above.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

**It** should be understood that the vertical memory device including the Ovonic threshold switching material described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. An Ovonic threshold switching material comprising germanium (Ge), antimony (Sb), and selenium (Se), wherein
a ratio of Ge among Ge, Sb, and Se is 10 at% or more and 40 at% or less,
a ratio of Sb among Ge, Sb, and Se is 10 at% or more and 40 at% or less,
a ratio of Se among Ge, Sb, and Se is 20 at% or more and 80 at% or less, and
the Ovonic threshold switching material is doped with indium (In).

2. The Ovonic threshold switching material of claim 1, wherein a doping concentration of In in the Ovonic threshold switching material is greater than 0 at% and less than or equal to 10 at%.

3. The Ovonic threshold switching material of claims 1 or 2, wherein a doping concentration of In in the Ovonic threshold switching material is 1 at% or more and 10 at% or less.

4. The Ovonic threshold switching material of any of claims 1-3, wherein a doping concentration of In in the Ovonic threshold switching material is 1.5 at% or more and 10 at% or less.

5. The Ovonic threshold switching material of any of claims 1-4, wherein a doping concentration of In in the Ovonic threshold switching material is 1 at% or more and 5 at% or less.

6. The Ovonic threshold switching material of any of claims 1-5, wherein a doping concentration of In in the Ovonic threshold switching material is 1.5 at% or more and 5 at% or less.

7. The Ovonic threshold switching material of any of claims 1-6, wherein
the ratio of Ge among Ge, Sb, and Se is 20 at% or more and 35 at% or less,
the ratio of Sb among Ge, Sb, and Se is 20 at% or more and 35 at% or less, and
the ratio of Se among Ge, Sb, and Se is 30 at% or more and 60 at% or less.

8. The Ovonic threshold switching material of any of claims 1-7, wherein a concentration of arsenic (As) in the Ovonic threshold switching material is 0 at%.

9. The Ovonic threshold switching material of any of claims 1-8, wherein a threshold voltage drift of the Ovonic threshold switching material is in a range from 6 mV/dec to 7 mV/dec.

10. A memory device comprising:
a plurality of word planes extending along a plane including a first direction and a second direction, the plurality of word planes spaced apart from each other in a third direction perpendicular to the first direction and the second direction;
a plurality of vertical bit lines extending in the third direction; and
a plurality of Ovonic threshold switching material layers surrounding a surface of each of the plurality of vertical bit lines and extending in the third direction,
wherein the plurality of Ovonic threshold switching material layers comprise the Ovonic threshold switching material of any of claims 1-9.

11. The memory device of claim 10, wherein
the plurality of Ovonic threshold switching material layers and the plurality of vertical bit lines pass through the plurality of word planes in the third direction and are two-dimensionally arranged in the first direction and the second direction, and
the plurality of word planes surround external surfaces of the plurality of Ovonic threshold switching material layers.

12. The memory device of claims 10 or 11, further comprising:
a plurality of dielectric layers surrounding external surfaces of the plurality of Ovonic threshold switching material layers, each of the plurality of dielectric layers being between two adjacent ones of the plurality of word planes that are adjacent to each other in the third direction.
